(19) Europäisches Patentamt
European Patent Office
Office européen des brevets

(11) **EP 2 056 352 A2**

(12) **EUROPEAN PATENT APPLICATION**

(43) Date of publication:
06.05.2009 Bulletin 2009/19

(51) Int Cl.:
*H01L 31/0224* (2006.01)  *H01L 31/18* (2006.01)

(21) Application number: 08162002.3

(22) Date of filing: 07.08.2008

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(30) Priority: 29.10.2007  US 926405

(71) Applicant: **Palo Alto Research Center
Incorporated
Palo Alto, California 94304 (US)**

(72) Inventors:
• **Allison, Kevin Warren
Goleta, 93117 (US)**

• **Fork, David K.
Los Altos, CA 94024 (US)**
• **Shaqfeh, Eric Stefan Garrido
Oakland, CA 94611 (US)**
• **Solberg, Scott E.
Mountain View, CA 94041 (US)**

(74) Representative: **Grünecker, Kinkeldey,
Stockmair & Schwanhäusser
Anwaltssozietät
Leopoldstraße 4
80802 München (DE)**

(54) **Co-extruded compositions for high aspect ratio structures**

(57)    A material set that can be used for making high aspect ratio lines includes a sacrificial feedstock comprising an organic polymer, a solvent, and one or more optional additives, and a functional material that forms a ribbon with the sacrificial feedstock without the sacrificial feedstock and the functional material substantially intermixing, wherein the sacrificial feedstock has a yield strength of greater than about 100 Pa or a viscosity of greater than about $10^4$ cP at a shear rate of less than about 10 sec$^{-1}$ to enable the ribbon to maintain structural integrity, and the sacrificial feedstock can be removed from the ribbon, leaving the functional material in place with an aspect ratio of greater than about 0.3.

FIG. 1

**Description**

TECHNICAL FIELD

This disclosure is generally directed to extruded ribbons of material, such as can be used for making relatively fine conductive or ceramic lines or structures, having relatively high aspect ratios, and materials that can be used in such extruded ribbons of material. More particularly, in embodiments, this disclosure is directed to a sacrificial feedstock for extrusion of ribbons, the sacrificial feedstock comprising an organic polymer, a solvent, and one or more optional additives, wherein the sacrificial feedstock has a yield strength of greater than about 100 Pa or a viscosity of greater than about $10^4$ cP at a shear rate of less than about 10 sec$^{-1}$ to enable the ribbon to maintain structural integrity, and the sacrificial feedstock can be removed from the ribbon, leaving the functional material in place with an aspect ratio of greater than about 0.3. Other embodiments are directed to extruded ribbons of material, methods of making such extruded ribbons, material used therefor, and uses thereof such as in solar cell manufacturing.

BACKGROUND

Solar cells are typically photovoltaic devices that convert sunlight directly into electricity. Solar cells commonly include a semiconductor (e.g., silicon) that absorbs light irradiation (e.g., sunlight) in a way that creates free electrons, which in turn are caused to flow in the presence of a built-in field to create direct current (DC) power. The DC power generated by several photovoltaic cells may be collected on a grid placed on the cell. Current from multiple photovoltaic cells is then combined by series and parallel combinations into higher currents and voltages. The DC power thus collected may then be sent over wires, often many dozens or even hundreds of wires.

The state of the art for metallizing silicon solar cells for terrestrial deployment is screen printing. Screen printing has been used for decades, but as cell manufacturers look to improve cell efficiency and lower cost by going to thinner wafers, the screen printing process is becoming a limitation. The screen printers run at a rate of about 1800 wafers per hour and the screens last about 5000 wafers. The failure mode often involves screen and wafer breakage. This means that the tools go down every couple of hours, and require frequent operator intervention. Moreover, the printed features are limited to about 100 microns wide and about 15 microns tall, and the material set is limited largely to silver for the front contact grid.

The desired but largely unavailable features in a wafer-processing tool for making solar cells are as follows: (a) never breaks a wafer - e.g. non contact; (b) one second processing time (i.e., 3600 wafers/hour); (c) large process window; and (d) 24/7 operation other than scheduled maintenance less than one time per week. The desired but largely unavailable features in a low-cost metal semiconductor contact for solar cells are as follows: (a) minimal contact area - to avoid surface recombination; (b) shallow contact depth - to avoid shunting or otherwise damaging the cell's pn junction; (c) low contact resistance to lightly doped silicon; and (d) high aspect metal features (for front contacts to avoid grid shading while providing low resistance to current flow).

Given the above set of desired features, the tool set for the next generation solar cell processing line is expected to look very different from screen printing. Since screen printing is an inherently low resolution contact method, it is unlikely to satisfy all of the criteria listed above. Solar cell fabrication is an inherently simple process with tremendous cost constraints. All of the printing that is done on most solar cells is directed at contacting and metallizing the emitter and base portions of the cell. The metallization process can be described in three steps, (1) opening a contact through the surface passivation, (2) making an electrical contact to the underlying silicon along with a robust mechanical contact to the solar cell and (3) providing a conducting path away from the contact.

Currently, the silver pastes used by the solar industry consist of a mixture of silver particles and a glass frit in an organic vehicle. Upon heating, the organic vehicle decomposes and the glass frit softens and then dissolves the surface passivation layer on the substrate, creating a pathway for silver to reach the silicon. The surface passivation, which may also serve as an anti-reflection coating, is a part of the cell that covers the cell in all but the electrical contact areas. The glass frit approach to opening contacts has the advantage that no separate process step is needed to open the passivation. The paste mixture is screened onto the wafer, and when the wafer is fired, a multitude of random point contacts are made under the silver pattern. Moreover, the upper portions of the paste densify into a metal thick film that carries current from the cell. These films form the gridlines on the wafer's front-side, and the base contact on the wafer's backside. The silver is also a surface to which the tabs that connect to adjacent cells can be soldered.

In the conventional screen printing approach to metallizing solar cells, a squeegee presses a paste through a mesh with an emulsion pattern that is held over the wafer. Feature placement accuracy is limited by factors such as screen warpage and stretching. The feature size is limited by the feature sizes of the screen and the rheology of the paste. Feature sizes below 100 microns wide are difficult to achieve, and as wafers become larger, accurate feature placement and registration becomes more difficult. Because it is difficult to precisely register one screen printed pattern with another screen printed pattern, most solar cell processes avoid registering multiple process steps through methods like the one described above in which contacts are both opened and metallized as the glass frit in the silver paste dissolves the nitride passivation.

The most common photovoltaic device cell design in production today is the front surface contact cell, which includes a set of gridlines on the front surface of the substrate that make contact with the underlying cell's emitter. Ever since the first silicon solar cell was fabricated over 50 years ago, it has been a popular sport to estimate the highest achievable conversion efficiency of such a cell. At one terrestrial sun, this so-called limit efficiency is now firmly established at about 29% (see Richard M. Swanson, "Approaching the 29% Limit Efficiency of Silicon Solar Cells" 31s IEEE Photovoltaic Specialists Conference, 2005). Laboratory cells have reached 25%. Only recently have commercial cells achieved a level of 20% efficiency. One successful approach to making photovoltaic devices with greater than 20% efficiency has been the development of backside contact cells. Backside contact cells utilize localized contacts that are distributed throughout p and n regions formed on the backside surface of the device wafer (i.e., the side facing away from the sun) to collect current from the cell. Small contact openings finely distributed on the wafer not only limit recombination but also reduce resistive losses by serving to limit the distance carriers must travel in the relatively less conductive semiconductor in order to reach the better conducting metal lines.

One route to further improvement is to reduce the effect of carrier recombination at the metal semiconductor interface in the localized contacts. This can be achieved by limiting the metal-semiconductor contact area to only that which is needed to extract current. Unfortunately, the contact sizes that are readily produced by low-cost manufacturing methods, such a screen printing, are larger than needed. Screen printing is capable of producing features that are on the order of 100 microns wide in size. However, provided that there is a sufficiently low contact resistance between the metal and the semiconductor, features on the order of 10 microns or smaller can suffice for extracting current. For a given density of holes, such size reduction will reduce the total metal-semiconductor interface area, and its associated carrier recombination, by a factor of 100.

The continual drive to lower the manufacturing cost of solar power makes it preferable to eliminate as many processing steps as possible from the cell fabrication sequence. As described in US Published Patent Application No. US2004/0200520 A1 by SunPower Corporation, typically, the current openings are formed by first depositing a resist mask onto the wafer, dipping the wafer into an etchant, such a hydrofluoric acid to etch through the oxide passivation on the wafer, rinsing the wafer, drying the wafer, stripping off the resist mask, rinsing the wafer and drying the wafer.

Presently, the majority of solar cells are manufactured using a screen printed process, which screen prints front and back contacts. The back contact is commonly provided as a layer of aluminum. The aluminum layer will cover most if not all the back layer of the silicon wafer, thereby blocking any light which would reflect onto the back surface of the silicon wafer. These types of solar cells therefore receive and convert sunlight only from the front exposed surface. However, another type of known solar cell is a bifacial solar cell, which acquires light from both surfaces of the solar cell and converts the light into electrical energy. Solar cells which are capable of receiving light on both surfaces are available on the market. One example is the HIT solar cell from Sanyo Corporation of Japan, as well as bifacial solar cells sold by Hitachi Corporation, also of Japan.

It is particularly desirable to provide feature placement with high accuracy for feature sizes below 100 microns. By minimizing the feature sizes, more surface area is available for the accumulation and conversion of solar light. Provided that there is a sufficiently low contact resistance, features on the order of 10 microns or smaller can suffice for extracting current. For a given density of features, such a size reduction may reduce the total metal-semiconductor interface area and its associated carrier recombination by a factor of 100.

However, screen printing of fine structures with high aspect ratio of thickness to width has well documented limitations. For example, screen printed grid metallization lines on solar cells have typical fired thickness of 10-20 microns with line widths of 100-200 microns. Thus, such screen printing techniques are usually limited to conductive lines having aspect ratios of only up to about 0.1 or 0.2.

SUMMARY

What is needed is a method and processing system for producing photovoltaic devices (solar cells) that overcomes the deficiencies of the conventional approach described above by both reducing the manufacturing costs and complexity, and improving the operating efficiency of the resulting photovoltaic devices. What is also needed is compositions and methods that can be used for making relatively fine conductive lines or structures, desirably having relatively high aspect ratios, for use in solar cells, fuel cells, and the like. Also needed is such compositions and methods that can be applied to making such fine lines or structures having relatively high aspect ratios, but that are applicable to ceramic materials, semiconductor dopant materials, and the like. These and other needs are addressed by embodiments of this disclosure.

In an embodiment, the present disclosure provides a sacrificial feedstock for extrusion of ribbons, the ribbons comprising sacrificial extrudate and high-aspect-ratio functional material, said sacrificial feedstock comprising:

an organic polymer,

a solvent, and

one or more optional additives,

wherein the sacrificial feedstock has a yield strength of greater than about 100 Pa or a viscosity of greater than about $10^4$ cP at a shear rate of less than about 10 sec$^{-1}$ to enable the ribbon to maintain structural integrity, and the sacrificial feedstock can be removed from the ribbon, leaving the functional material in place with an aspect ratio of greater than about 0.3. The sacrificial material can also be included in a material set, comprising the sacrificial feedstock and a functional material that forms a ribbon with the sacrificial feedstock without the sacrificial feedstock and the functional material substantially intermixing.

In another embodiment, the present disclosure provides an extruded ribbon of material, comprising:

a functional material having an aspect ratio of 0.3 or greater, and

an unfilled sacrificial material on at least one side of the functional material, the sacrificial material comprising an organic polymer, a solvent, and one or more optional additives,

wherein the sacrificial material has a yield strength of greater than about 100 Pa or a viscosity of greater than about $10^4$ cP at a shear rate of less than about 10 sec$^{-1}$ to enable the ribbon to maintain structural integrity, and the sacrificial material can be removed from the ribbon, leaving the functional material in place with an aspect ratio of greater than about 0.3.

In still another embodiment, the present disclosure provides a combination comprising:

a substrate, and

an extruded ribbon of material on said substrate, said extruded ribbon comprising:

a functional material having an aspect ratio of 0.3 or greater, and

an unfilled sacrificial material on at least one side of the functional material, the sacrificial material comprising an organic polymer, a solvent, and one or more optional additives,

wherein the sacrificial material has a yield strength of greater than about 100 Pa or a viscosity of greater than about $10^4$ cP at a shear rate of less than about 10 sec$^{-1}$ to enable the ribbon to maintain structural integrity, and

the sacrificial material can be removed from the ribbon, leaving the functional material in place with an aspect ratio of greater than about 0.3.

In a further embodiment, the present disclosure provides a method for forming conductive lines on a substrate, comprising:

extruding a ribbon of a functional material having an aspect ratio of 0.3 or greater and a sacrificial material on at least one side of the functional material,

wherein the sacrificial material comprises an organic polymer, a solvent, and one or more optional additives,

the sacrificial material has a yield strength of greater than about 100 Pa or a viscosity of greater than about $10^4$ cP at a shear rate of less than about 10 sec$^{-1}$ to enable the ribbon to maintain structural integrity, and

the sacrificial material can be removed from the ribbon, leaving the functional material in place with an aspect ratio of greater than about 0.3.

The materials and methods of the disclosure can be used, for example, to provide a solar cell structure, comprising:

a substrate; and

at least one gridline formed on the substrate,

wherein the at least one gridline has an aspect ratio of at least about 0.3 and is formed by a method comprising extruding onto the substrate a ribbon of a functional material having an aspect ratio of 0.3 or greater and a sacrificial material on at least one side of the functional material,

wherein the sacrificial material comprises an organic polymer, a solvent, and one or more optional additives,

the sacrificial material has a yield strength of greater than about 100 Pa or a viscosity of greater than about $10^4$ cP at a shear rate of less than about 10 sec$^{-1}$ to enable the ribbon to maintain structural integrity, and

the sacrificial material can be removed from the ribbon, leaving the functional material in place with an aspect ratio of greater than about 0.3.

BRIEF DESCRIPTION OF THE DRAWINGS

FIG. 1 shows a photovoltaic (solar) cell including gridlines formed in accordance with the present disclosure.
FIG. 2 shows a simplified cross-sectional side view showing a portion of an exemplary plasma display panel.
FIG. 3 shows a plot of shear viscosity (in Pa-s) versus shear rate (in 1/sec) for the materials of Example 3.

DETAILED DESCRIPTION OF EXEMPLARY EMBODIMENTS

The present invention provides in embodiments:

(1) a sacrificial feedstock for extrusion of ribbons, the ribbons comprising sacrificial extrudate and high-aspect-ratio functional material, said sacrificial feedstock comprising:

an organic polymer,
a solvent, and
one or more optional additives,
wherein the sacrificial feedstock has a yield strength of greater than about 100 Pa or a viscosity of greater than about $10^4$ cP at a shear rate of less than about 10 sec$^{-1}$ to enable the ribbon to maintain structural integrity, and the sacrificial feedstock can be removed from the ribbon, leaving the functional material in place with an aspect ratio of greater than about 0.3.

(2) The sacrificial feedstock of (1), wherein a viscosity of the sacrificial feedstock is <= about five times a viscosity of the functional material at a shear rate of greater than about > 100 sec$^{-1}$.
(3) The sacrificial feedstock of (1), wherein the sacrificial feedstock has one or more rheological properties that are substantially the same as the same rheological properties of the functional material.
(4) The sacrificial feedstock of (3), wherein the one or more rheological properties are selected from the group consisting of the shear and extensional viscosity, the loss and storage modulus, the primary and secondary normal stress coefficient, the elastic flow relaxation time, the flow consistency index, the flow behavior index, the yield stress, and the surface tension.
(5) The sacrificial feedstock of (1), wherein the sacrificial feedstock has one or more rheological properties that are lower that the same rheological properties of the functional material.
(6) The sacrificial feedstock of (1), wherein the functional material is selected from the group consisting of a conductive material, a material comprising a semiconductor dopant, a photoresist material, and a ceramic material.
(7) The sacrificial feedstock of (1), wherein the sacrificial feedstock can be removed from the ribbon, leaving the functional material in place with an aspect ratio of from about 0.4 to about 10.
(8) The sacrificial feedstock of (1), wherein the sacrificial material consists essentially of the solvent, the organic polymer, and one or more optional additives selected from the group consisting of thixotropic agents, gelling agents, plasticizers, co-solvents, wetting agents, and viscosity modifiers or builders.
(9) The sacrificial feedstock of (1), wherein the solvent has a boiling point of from about 130 to about 350°C.
(10) The sacrificial feedstock of (1), wherein the solvent is selected from the group consisting of kerosene, mineral spirits, terpineol, esters of phthalic acid, butyl carbitol, butyl carbitol acetate, hexylene glycol, aliphatic di-esters, high-boiling alcohols and alcohol esters, and mixtures thereof.
(11) The sacrificial feedstock of (1), wherein the organic polymer is selected from the group consisting of ethyl cellulose, ethylhydroxyethyl cellulose, wood rosin, mixtures of ethyl cellulose and phenolic resins, polymethacrylates of lower alcohols, and monobutyl ether of ethylene glycol monoacetate, and mixtures thereof.
(12) The sacrificial feedstock of (1), wherein the sacrificial feedstock further comprises a thixotropic agent.
(13) The sacrificial feedstock of (12), wherein the thixotropic agent is selected from the group consisting of hydrogenated castor oil and derivatives thereof, non-hydrogenated castor oil and derivatives thereof, and ethyl cellulose.
(14) The sacrificial feedstock of (1), wherein the sacrificial feedstock comprises about 25 to about 99% solvent, about 0 to about 40% plasticizer or co-solvent, about 1 to about 30% organic polymer, and about 0 to about 10% other additives.
(15) The sacrificial feedstock of (1), wherein the sacrificial feedstock is an unfilled material having about 2% or less by volume of discrete solid or gel-like particles.
(16) The sacrificial feedstock of (1), wherein the ribbon is extrudable onto a substrate and the sacrificial feedstock maintains the functional material in place with an aspect ratio of greater than about 0.3 prior to removal of the sacrificial feedstock.

(17) The sacrificial feedstock of (1), wherein the sacrificial feedstock is removable from said ribbon by a process that maintains functional properties of the functional material.

(18) The sacrificial feedstock of (17), wherein the sacrificial feedstock is removable from said ribbon by a process selected from the group consisting of pyrolysis, burning, dissolution, dispersion, and washing.

(19) A material set, comprising:

a sacrificial feedstock comprising an organic polymer, a solvent, and one or more optional additives, and
a functional material that forms a ribbon with the sacrificial feedstock without the sacrificial feedstock and the functional material substantially intermixing,

wherein the sacrificial feedstock has a yield strength of greater than about 100 Pa or a viscosity of greater than about $10^4$ cP at a shear rate of less than about 10 sec$^{-1}$ to enable the ribbon to maintain structural integrity, and the sacrificial feedstock can be removed from the ribbon, leaving the functional material in place with an aspect ratio of greater than about 0.3.

(20) The material set of (19), wherein the functional material is a conductive ink or conductive ink precursor composition comprising metal particles, an electronic glass, an organic component, and one or more optional additives.

(21) The material set of (20), wherein the metal particles are particles of a metal selected from the group consisting of Al, Pd, Ag, Pt, Au, Cu, Ni, alloys including one or more of the aforementioned metals, and oxide precursors thereof.

(22) The material set of (20), wherein the metal particles are particles of a metal selected from the group consisting of aluminum and silver.

(23) The material set of (20), wherein the metal particles are in the form of spherical particles, potato-shaped particles, flakes, or slivers.

(24) The material set of (20), wherein the metal particles have an average major dimension of from about 0.05 to about 20 microns.

(25) The material set of (20), wherein the metal particles comprise particles in the form of flakes.

(26) The material set of (25), wherein the metal particle flakes have an average major dimension of from about 0.05 to about 20 microns.

(27) The material set of (20), wherein the metal particles comprise metal flakes, and from about 5% to about 40% by weight of metal spherical particles having an average particle size of from about 50 nm to about 200 nm.

(28) The material set of (27), wherein the metal particles further comprise metal spherical particles having an average particle size of from about 1 to about 15 microns.

(29) The material set of (20), wherein more than about 50% of the metal particles have a major dimension that is greater than about 1 micron.

(30) The material set of (20), further comprising an organometallic compound or metal resinate.

(31) The material set of (20), wherein the organic component comprises a solvent, an organic polymer, and one or more optional additives.

(32) The material set of (31), wherein the one or more optional additives are selected from the group consisting of thixotropic agents, gelling agents, plasticizers, co-solvents, wetting agents, and viscosity modifiers or builders.

(33) The material set of (31), wherein the solvent has a boiling point of from about 130 to about 350°C.

(34) The material set of (31), wherein the solvent is selected from the group consisting of aliphatic di-esters, kerosene, mineral spirits, terpineol, esters of phthalic acid, butyl carbitol, butyl carbitol acetate, hexylene glycol, high-boiling alcohols and alcohol esters, and mixtures thereof.

(35) The material set of (31), wherein the organic polymer is selected from the group consisting of ethyl cellulose, ethylhydroxyethyl cellulose, wood rosin, mixtures of ethyl cellulose and phenolic resins, polymethacrylates of lower alcohols, and monobutyl ether of ethylene glycol monoacetate, and mixtures thereof.

(36) The material set of (31), further comprising a thixotropic agent.

(37) The material set of (36), wherein the thixotropic agent is selected from the group consisting of hydrogenated castor oil and derivatives thereof, non-hydrogenated castor oil and derivatives thereof, and ethyl cellulose.

(38) The material set of (20), wherein the organic component comprises about 25 to about 99% solvent, about 0 to about 40% plasticizer or co-solvent, about 1 to about 30% organic polymer, and about 0 to about 10% other additives.

(39) The material set of (20), wherein the electronic glass is selected from the group consisting of PbO/ZnO glass, $SiO_2$ glass, $TiO_2$ glass, $B_2O_3$ glass, $ZrO_2$ glass, $SiO_2/Bi_2O_3/PbO$, $B_2O_3/SiO_2/Bi_2O_3$, $Bi_2O_3/SiO_2/ZnO$, $Bi_2O_3/SiO_2/PbO$, and mixtures thereof.

(40) The material set of (20), wherein the electronic glass is a lead-free glass.

(41) The material set of (20), comprising about 50 to about 90% metal particles, about 1 to about 10% electronic glass, and about 5 to about 40% organic component.

(42) The material set of (20), the functional material further comprising a sintering inhibitor.

(43) The material set of (42), wherein the sintering inhibitor is in a form of separate particulates, organometallic compounds that are soluble in the organic component, or a coating on the metal particles.

(44) The material set of (42), wherein the sintering inhibitor is selected from the group consisting of oxides of rhodium, oxides of ruthenium, and rhodium- and ruthenium-based compounds that, under the firing conditions which they are subjected to, are changed to oxides of the metal.

(45) The material set of (42), wherein the sintering inhibitor is selected from the group consisting of Ru metal, $RuO_2$, Ru-based pyrochlore compounds, Ru resonates, Rh metal, $RhO_2$, $Rh_2O_3$, Rh resonates, and mixtures thereof.

(46) The material set of (19), wherein the sacrificial feedstock is of substantially the same composition as the functional material, except that the sacrificial feedstock is substantially free of conductive metal particles and electronic glass.

(47) The material set of (19), wherein the sacrificial feedstock has a viscosity of about 0.1 to about 300 Pa.s when measured at about 20°C on a Brookfield viscometer at low, moderate and high shear rates.

(48) The material set of (19), wherein the sacrificial material burns out during a sintering process of the functional material at about 600 to about 800°C for a time period of less than one minute.

(49) The material set of (48), wherein the sacrificial feedstock completely burns out during the sintering process.

(50) The material set of (19), wherein the functional material in the ribbon in its unfired state has a width of from about 10 to about 100 microns and a thickness of from about 25 to about 200 microns.

(51) The material set of (19), wherein the functional material in the ribbon in its unfired state has a width of from about 10 to about 75 microns and a thickness of from about 25 to about 100 microns.

(52) An extruded ribbon of material, comprising:

a functional material having an aspect ratio of 0.3 or greater, and
an unfilled sacrificial material on at least one side of the functional material, the sacrificial material comprising an organic polymer, a solvent, and one or more optional additives,
wherein the sacrificial material has a yield strength of greater than about 100 Pa or a viscosity of greater than about $10^4$ cP at a shear rate of less than about 10 sec$^{-1}$ to enable the ribbon to maintain structural integrity, and the sacrificial material can be removed from the ribbon, leaving the functional material in place with an aspect ratio of greater than about 0.3.

(53) The extruded ribbon of (52), wherein the functional material is a conductive ink comprising metal particles, an electronic glass, an organic component, and one or more optional additives.

(54) The extruded ribbon of (53), wherein the organic component comprises a solvent, an organic polymer, and one or more optional additives.

(55) The extruded ribbon of (52), wherein the sacrificial material is extruded on only one side of the functional material.

(56) The extruded ribbon of (52), wherein the sacrificial material is extruded on two opposite sides of the functional material.

(57) The extruded ribbon of (52), wherein the sacrificial material is coextruded with the functional material.

(58) The extruded ribbon of (52), wherein the sacrificial material satisfies one or both of the following properties:

1) it substantially does not include any filler materials; and
2) it burns out during firing or sintering of the functional material, such that the sacrificial material is substantially removed from the substrate.

(59) The extruded ribbon of (52), wherein the sacrificial material is of substantially the same composition as the functional material, except that conductive metal particles and electronic glass are excluded from the sacrificial material.

(60) The extruded ribbon of (52), wherein the sacrificial material comprises an organic component that comprises a solvent, an organic polymer, and one or more optional additives.

(61) The extruded ribbon of (60), wherein the sacrificial material consists essentially of the organic component.

(62) The extruded ribbon of (52), wherein the sacrificial material does not include a filler material that would not burn-out during a sintering process of the functional material at about 600 to about 800°C for a time period of less than one minute.

(63) The extruded ribbon of (52), wherein the functional material in its unfired state has a width of from about 10 to about 100 microns and a thickness of from about 25 to about 200 microns.

(64) The extruded ribbon of (52), wherein the functional material in its unfired state has a width of from about 10 to about 75 microns and a thickness of from about 25 to about 100 microns.

(65) The extruded ribbon of (52), wherein the functional material in its unfired state has an aspect ratio of from about 0.4 to about 10.

(66) A combination comprising:

a substrate, and
an extruded ribbon of material on said substrate, said extruded ribbon comprising:

a functional material having an aspect ratio of 0.3 or greater, and
an unfilled sacrificial material on at least one side of the functional material, the sacrificial material comprising an organic polymer, a solvent, and one or more optional additives,
wherein the sacrificial material has a yield strength of greater than about 100 Pa or a viscosity of greater than about $10^4$ cP at a shear rate of less than about 10 sec$^{-1}$ to enable the ribbon to maintain structural integrity, and
the sacrificial material can be removed from the ribbon, leaving the functional material in place with an aspect ratio of greater than about 0.3.

(67) The combination of (66), wherein the substrate is a silicon substrate.
(68) The combination of (66), wherein the combination is used in forming a solar cell, a fuel cell, or a plasma display panel.
(69) The combination of (66), wherein the extruded ribbon is a coextruded ribbon.
(70) A method for forming conductive lines on a substrate, comprising:

extruding a ribbon of a functional material having an aspect ratio of 0.3 or greater and a sacrificial material on at least one side of the functional material,
wherein the sacrificial material comprises an organic polymer, a solvent, and one or more optional additives,
the sacrificial material has a yield strength of greater than about 100 Pa or a viscosity of greater than about $10^4$ cP at a shear rate of less than about 10 sec$^{-1}$ to enable the ribbon to maintain structural integrity, and
the sacrificial material can be removed from the ribbon, leaving the functional material in place with an aspect ratio of greater than about 0.3.

(71) The method of (70), further comprising sintering the functional material.
(72) The method of (71), wherein the sintering bums-off the sacrificial material.
(73) The method of (71), wherein the sintering is at about 600 to about 800°C for a time period of less than one minute.
(74) The method of (71), wherein the sintering is conducted under normal atmosphere or under an inert atmosphere.
(75) The method of (70), wherein the sacrificial material is extruded on only one side of the functional material.
(76) The method of (70), wherein the sacrificial material is extruded on two opposite sides of the functional material.
(77) The method of (70), wherein the functional material comprises metal particles, an electronic glass, an organic component, and one or more optional additives.
(78) The method of (77), wherein the sacrificial material is of substantially the same composition as the functional material, except that conductive metal particles and electronic glass are excluded from the sacrificial material.
(79) The method of (70), wherein the sacrificial material comprises an organic component that comprises a solvent, an organic polymer, and one or more optional additives.
(80) The method of (70), wherein the sacrificial material does not include a filler material that would not burn-out during a sintering process of the conductive ink at about 600 to about 800°C for a time period of less than one minute.
(81) The method of (70), wherein the sacrificial material burns out during a sintering process of the conductive ink at about 600 to about 800°C for a time period of less than one minute.
(82) The method of (81), wherein the sacrificial material completely burns out during the sintering process.
(83) The method of (70), wherein the ink composition in its unfired state has a width of from about 10 to about 100 microns and a thickness of from about 25 to about 200 microns.
(84) The method of (70), wherein the ink composition in its unfired state has a width of from about 10 to about 75 microns and a thickness of from about 25 to about 100 microns.
(85) The method of (70), wherein the ink composition in its unfired state has an aspect ratio of from about 0.4 to about 10.
(86) A solar cell structure, comprising:

a substrate; and
at least one gridline formed on the substrate,
wherein the at least one gridline has an aspect ratio of at least about 0.3 and is formed by a method comprising extruding onto the substrate a ribbon of a functional material having an aspect ratio of 0.3 or greater and a sacrificial material on at least one side of the functional material,
wherein the sacrificial material comprises an organic polymer, a solvent, and one or more optional additives,
the sacrificial material has a yield strength of greater than about 100 Pa or a viscosity of greater than about $10^4$

cP at a shear rate of less than about 10 sec$^{-1}$ to enable the ribbon to maintain structural integrity, and the sacrificial material can be removed from the ribbon, leaving the functional material in place with an aspect ratio of greater than about 0.3.

(87) The solar cell structure of (86), wherein the gridline is formed on only one side of the substrate.

(88) The solar cell structure of (86), wherein the gridline is formed on two opposite sides of the substrate.

(89) The solar cell structure of (86), wherein the gridline has a width of from about 10 to about 100 microns and a thickness of from about 25 to about 200 microns.

(90) The solar cell structure of (86), wherein the gridline has a width of from about 10 to about 75 microns and a thickness of from about 25 to about 100 microns.

(91) The solar cell structure of (86), wherein the gridline has an aspect ratio of from about 0.3 to about 15.

(92) The solar cell structure of (86), wherein the gridline has an aspect ratio of from about 0.4 to about 10.

(93) The solar cell structure of (86), wherein the substrate is a semiconductor substrate having a p-type region and an n-type region.

(94) The solar cell structure of (86), wherein the substrate is formed from a semiconductor material selected from the group consisting of aluminum arsenide, aluminum gallium arsenide, boron nitride, cadmium sulfide, cadmium selenide, copper indium gallium selenide, diamond, gallium arsenide, gallium nitride, germanium, indium phosphide, silicon, silicon carbide, silicon nitride, silicon germanium, silicon on insulator, zinc sulfide, and zinc selenide.

(95) The solar cell structure of (86), wherein the substrate has an upper surface and a lower surface, the at least one gridline being formed on the upper surface, and a metal contact is formed on the lower surface.

(96) The solar cell structure of (95), further comprising a bus bar formed on the upper surface.

(97) The solar cell structure of (95), wherein the upper surface further comprises a textured surface or an antireflection material coated thereon.

(98) The solar cell structure of (86), the method further comprising sintering the conductive ink.

(99) The solar cell structure of (98), wherein the sintering burns-off the sacrificial material.

(100) The solar cell structure of (98), wherein the sintering is at about 600 to about 800°C for a time period of less than one minute.

(101) The solar cell structure of (86), further comprising a clear material over the gridlines.

(102) The solar cell structure of (101), wherein the clear material is selected from the group consisting of a glass sheet, a plastic sheet, plastic encapsulation, and spin-on glass.

According to embodiments of the disclosure, there are provided compositions, methods, products, and uses of an extruded ribbon of material, generally comprising a functional material having an aspect ratio of 0.3 or greater, and a sacrificial feedstock on at least one side of the functional material, the sacrificial feedstock generally comprising an organic polymer, a solvent, and one or more optional additives, wherein the sacrificial feedstock has a yield strength of greater than about 100 Pa or a viscosity of greater than about 10$^4$ cP at a shear rate of less than about 10 sec$^{-1}$ to enable the ribbon to maintain structural integrity, and the sacrificial feedstock can be removed from the ribbon, leaving the functional material in place with an aspect ratio of greater than about 0.3. The functional material can be, for example, a conductive ink, a ceramic material, or a semiconductor dopant composition. The functional material and the sacrificial feedstock can have one or more rheological properties that are substantially the same as each other. The extruded ribbon of material can be applied to a substrate, such as a silicon substrate, by extrusion of the material through a suitable applicator. The extruded ribbon of material can thereafter be processed, such as fired, to provide a line or ribbon, such as conductive or ceramic, on the substrate. The extruded ribbon of material is useful, for example, in forming solar cells, fuel cells, or the like, where conductive or ceramic or the like lines of high aspect ratio are desired.

The term "ribbon" refers, for example, to a side-by-side combination of at least a sacrificial feedstock and a functional material, where the sacrificial feedstock helps support the structure of the functional material on at least one, and optionally two or more, sides. The ribbon of material can have a square or rectangular cross-section, or can have a triangular or other shaped cross-section, as desired. In general, the ribbon is also longer in a longitudinal direction of the respective sacrificial feedstock and functional material directions than it is wide. For example, the ribbon generally refers to a strip of the sacrificial feedstock and functional material with a length that is at least two or at least five times greater in length than in each of width and height (or thickness).

In embodiments herein, the ribbon materials, such as sacrificial feedstock and functional material, completely or substantially do not intermix. That is, while the sacrificial feedstock may support the structure and integrity of the functional material, it is desired that components from one of the materials do not intermix into the other material. Such intermixing can be avoided or minimized, for example, thermodynamically (such as the sacrificial feedstock and functional material are insoluble in each other), or dynamically (such as due to viscosity, diffusivity, or the like).

The term "aspect ratio" refers, for example, to a comparison of the thickness of a structure and the width of the structure, where the thickness, or height, of the structure is taken as the dimension normal to the substrate. The ratio can be expressed either as a ratio (such as thickness:width) or as a number (such as thickness divided by width). Thus, when referring to a conductive metal line that has a thickness or height of 100 microns and a width of 50 microns, the aspect ratio can be expressed as 2:1 or 2.0.

In embodiments, any suitable functional material can be used, depending upon the end objectives of the process. For example, where the objective is to form conductive lines on a substrate, the functional material can be a conductive ink. However, the functional material is not limited to such conductive inks. Thus, for example, where the objective is to form ceramic lines on a substrate, the functional material can include a ceramic material such that when the extruded ribbon of functional material is fired, the result is a pattern of ceramic lines. In a similar manner, the functional material can comprise photoresist materials such that when the extruded ribbon of functional material is fired, the result is a pattern of photoresist lines of the desired high aspect ratio.

In a still further embodiment, the functional material can include semiconductor dopant materials, such as materials that can migrate from the functional material into an underlying semiconductor substrate. Thus, for example, the processes of the present disclosure can be used to apply a functional material comprising semiconductor dopant materials in the form of fine high aspect ratio lines. Upon firing, the semiconductor dopant materials can migrate from the functional material lines into the underlying semiconductor substrate, to form fine lines of doped material in the substrate itself.

Compositions of these, and other, functional materials will be apparent to those skilled in the art. Thus, while the present disclosure is not limited to conductive inks as the functional material, the disclosure will be illustrated in more detail with reference to a conductive ink functional material. Further it is understood that the function desired and provided by the functional material, such as conductivity or the like, need not be present initially in the ribbon of material, but instead may arise or increase during processing of the ribbon. Thus, for example, in the case of a functional material ink composition that is to form conductive lines, the functional material itself need not be conductive or can be of low conductance, although it can become more conductive after firing the functional material.

When the functional material is a conductive ink, any suitable conductive ink (also sometimes referred to in the art as a conductive "paste") can be used in embodiments, including a wide range of conductive inks that are well known in the art, particularly for forming conductive lines for solar cell applications. Other suitable ink compositions include those ink compositions that are known in the art for thick film formation, such as for forming photoresists and the like. Such conductive inks generally comprise metal particles, an electronic glass, and an organic component, where the organic component can include, for example, a solvent, a combined plasticizer/solvent material, organic polymer, viscosity modifiers or builders, gelling agents, and the like. Generally, such compositions are referred to by the primary metal component included in the ink composition. Thus, an ink composition primarily containing silver as the main metal component is referred to as a "silver ink" while an ink composition primarily containing aluminum as the main metal component is referred to as an "aluminum ink." Examples of specific suitable ink compositions are disclosed, for example, in U.S. Patent No. 4,954,926, the entire disclosure of which is incorporated herein by reference, although the ink composition in embodiments is not limited thereto.

Conductive metals that can be used in the ink of embodiments include any suitable metals used in the art, in suitable forms and in suitable amounts. For example, exemplary metals that can be included in the ink composition include, but are not limited to, Al, Pd, Ag, Pt, Au, Cu, Ni, Co, alloys including one or more of the aforementioned metals optionally with other metals, and oxide precursors thereof. The term "oxide precursor" refers, for example, to metal oxides that under normal thick film firing conditions are reduced to the metallic zero valent form ($Me^0$).

The particle shape, size and particle size distribution of the conductive metal particles is not particularly critical with respect to the effectiveness of the ink composition. Thus, for example, in embodiments, the metal particles can be provided in any suitable shape, such as spherical particles, non-spherical particles (such as potato-shaped particles or the like), flakes, slivers, or the like. Although not limited to any particular size, it is desired in embodiments that a major dimension, meaning the diameter of a spherical particle, or the largest dimension of a non-spherical shaped particle, of the metal particles not exceed about 10 or about 20 microns, such as from about 0.05 or about 0.1 to about 10 or about 20 microns. Thus, for example, where the metal particles are spherical particles, it is desired that the average particle size or diameter be from about 0.05 or about 0.1 to about 10 or to about 20 microns, such as from about 0.3 or about 0.5 or about 1 to about 3 or about 5 microns. Likewise, where the metal particles are elongate (such as slivers, flakes, or the like) it is desired that the average length or major dimension of the particles be from about 0.05 or about 0.1 to about 10 or to about 20 microns, and a minor dimension, meaning the smallest size dimension of a non-spherical shaped particle, from about 0.3 or about 0.5 or about 1 to about 3 or about 5 microns. Any particular particle size distribution is suitable, so long as the objectives can be achieved. For example, any particle size can be used, as long as the major dimension of the particles do not exceed or approximate the channel size of the extruder used for applying the ink composition. Such larger sized particles could tend to clog the extruder channels.

In one particular embodiment, it is desired that the metal particles be provided in the form of flakes rather than generally spherical particles. Such flakes can be obtained from commercial sources, or can be formed in a variety of methods. For example, flakes can be formed by flattening, such as pounding, silver particles, or they can be formed by first forming a thin layer of material on a surface, and then flaking the layer off in small pieces. Other methods will also be apparent to those skilled in the art.

A flake particle morphology is desired, in embodiments, as the flakes have been found to provide improved results over spherical particles in terms of increased adhesion and decreased lamination during the sintering process. For example, an ink composition having the metal particles in the form of flakes, rather than comparably sized spherical particles, tend to sinter at a lower rate and into a lower density structure, which helps to match the thermal expansion characteristics of the ink composition and the silicon substrate. The more closely matched thermal expansion characteristics helps to avoid delamination during sintering.

When flake-shaped metal particles are used, the flake shape may sometimes remain visible or detectable in the final sintered material. For example, scanning electron microscopy can sometimes reveal flake-shaped particles in the final sintered product. However, depending upon the sintering results and other materials in the ink composition, the flake shape may sometimes not be evident in the final product.

In one embodiment, particularly where flake-shaped particles are used, it is desired that the metal particle component of the ink composition completely or substantially exclude nanometer-sized particles, such as spherical or substantially spherical particles having particle sizes of up to about 200 nm, such as about 50 or about 100 nm to about 200 nm. Such nanometer-sized particles are desirably excluded because such small particles tend to sinter at a much faster rate, which can lead to undesired higher chances of delamination during the firing process. For example, in embodiments, it is desired that if such nanometer-sized particles are present, they be present in an amount of no more than about 30 or about 40% by weight of the total metal particle content, such as in amounts of from about 5% or about 10% to about 30% or about 40% by weight. In these amounts, the smaller sized particles can help fill in interstitial spaces between the larger particles, to increase the packing density and the sintering rate. The remaining metal particle component can be flakes, larger sized spheres, and the like.

In still another embodiment where metal flakes are used, it is desired that the metal particles include not only the metal flakes, but also metal spherical particles. These spherical particles, and desirably spherical particles that are larger than the nanometer-sized particles, help to hold the metal flakes apart during the firing process. Mismatched sized spheres, that is, spheres of different average particle sizes, can also be used.

Where flakes are used as the metal particles, the metal flakes desirably have a major dimension of from about 1 to about 10 microns, such as about 2 to about 3 microns. Where spherical particles are used as the metal particles, the spherical particles desirably have an average diameter of from about 1 to about 15 microns, such as about 1 or about 5 microns to about 10 microns. Unless otherwise noted, the sizes expressed herein are expressed in terms of the $D_{50}$ value, or the middle of the particle size distribution.

In terms of excluding small, nanometer-sized particles, it is desired in some specific embodiments that a majority of the metal particles, in terms of the number of particles, have a size (major dimension) that is greater than about 1 micron. Thus, in these embodiments, at least 50%, at least about 60%, at least about 70%, or at least about 80% of the metal particles have a size (major dimension) that is greater than about 1 micron. In still other embodiments, such as where both flake and spherical shaped particle are used, the metal particles can be provided such that a majority of the flake-shaped particles have a size (major dimension) that is greater than about 1 micron, and a majority of the spherical particles have a size (major dimension) that is greater than about 2 microns.

In addition to the metal particles, the ink composition can in embodiments also include an organometallic compound. If included, the organometallic compound generally can comprise a metal or metal oxide moiety that is insoluble in the electrically conductive metal and/or the oxide(s) of the metal moiety are non-reducing in the presence of the electrically conductive metal. The terms "organometallic compound" and "metal resinate" are used synonymously and refer, for example, to organic metallic compounds that are soluble in the various organic media suitable for use with the ink.

One type of metal resinate is the reaction product of any of several organic compounds with a metal salt. The resulting compound is essentially a long chain organic molecule in which one site is occupied by one of a wide variety of metals. Another type of metal resinate is a chelate-type compound such as an organotitanate.

The composition of the organic moiety of the organometallic compound is not critical except that it should be pyrolyzable when the ink composition is fired in either oxidizing or non-oxidizing atmospheres. These organic moieties include, but are not limited to, carboxylate naphthenates, tallates, alcoholates, and the like.

Suitable organometallic compounds may range from highly fluid to very viscous liquids and to solids as well. From the standpoint of use in ink compositions of embodiments, the solubility of the resinates in the organic medium is of primary importance. Typically, metal resinates are soluble in organic solvents, particularly polar solvents such as toluene, methylene chloride, benzyl acetate, and the like. They may also be soluble in non-polar solvents such as mineral spirits. Metal resinates and metal resinate solutions of both noble metals and base metals are commercially available. Suitable noble metal resinates are those based on Ru, Rh, Re, Ir, Pt and mixtures thereof. Suitable base metal resinates are those based on Mg, Si, Ti, V, Cr, Mn, Fe, Co, Ni, Cu, Zn, Zr, Nb, Ba, Ce, Ta, W and mixtures thereof.

Suitable organotitanates include those disclosed in U.K. Patent No. 772,675, and particularly those in which the organotitanates are hydrolyzable metal alcoholates of titanium corresponding to the formula $(AO)_{4x-2y}TiO_y$ in which A is $C_{1-8}$ alkyl or a mixture of $C_{1-8}$ alkyl and $C_{1-8}$ acyl, O is an oxygen atom covalently bonding two titanium atoms, x is an integer from 1 to 12 and y is an integer from 1 to 3x/2. The alkyl groups may be either straight chained or branched. Particularly suitable organotitanates include titanium acetyl acetonate and tetraoctylene glycol titanium chelate. Other organotitanates of this type are disclosed in Ken-React Bul. No. KR-0278-7 Rev. (Kenrich Petrochemicals, Inc., Bayonne, NJ) and in Du Pont Bul. No. E-38961 entitled Versatile Tyzor Organic Titanates.

The metal resinates, when present, are used in the compositions of the invention in concentrations such that the metal or metal oxide content of the resinate constitutes 0.05-5% wt., of the total composition, and preferably 0.1-1 % wt.

When present, it is particularly desirable that the organometallic compound be soluble in the rest of the organic medium in order to effect complete and uniform dispersion of the compound within the organic medium. When such uniform dispersion is achieved, it is believed that the organometallic material attaches to the surface of the conductive metal particles and then, as firing continues, decomposes to form the corresponding metal or metal oxide before the conductive metal particles begin to sinter.

A second component of the organic medium, in addition to or without the above organometallic compound, is the solution of polymeric binder in an organic solvent. The main purpose of this part of the organic medium is to serve as a vehicle for dispersion of the finely divided solids of the composition in such form that it can readily be applied to ceramic, silicon, or other substrates. Thus, this portion of the organic medium generally is one in which the solids are dispersible with an adequate degree of stability, and in which the rheological properties are such that they lend good application properties to the dispersion.

Most thick film compositions are applied to a substrate by means of screen printing. However, according to the disclosure, the ink composition is applied by an extruder, such as a microextruder. Therefore, the ink composition generally has appropriate viscosity so that it can be passed through the extruder die, such as by suitable positive or negative pressure. In addition, the ink compositions can be thixotropic in order that they set up rapidly after being extruded, thereby giving good resolution. Alternately, the ink compositions can include a light-curing additive that causes the ink to increase viscosity or harden when exposed to light such as high intensity ultraviolet light. While the rheological properties are of primary importance, the organic medium is desirably formulated also to give appropriate wettability of the solids and the substrate, good drying rate, dried film strength sufficient to withstand rough handling, and good firing properties. Satisfactory appearance of the fired composition is also important.

In view of these criteria, a wide variety of polymers and solvents can be used as the principal dispersion medium. The dispersion medium for most thick film compositions is typically a solution of resin in a solvent, frequently also containing one or more thixotropic agents, gelling agents, plasticizers, co-solvents, wetting agents, or the like. The solvent usually boils within the range of about 130 to about 350°C.

The most frequently used resin for this purpose is ethyl cellulose. However, other known and after-developed resins, such as ethylhydroxyethyl cellulose, wood rosin, mixtures of ethyl cellulose and phenolic resins, polymethacrylates of lower alcohols, and monobutyl ether of ethylene glycol monoacetate, including combinations of two or more different resins, can also be used in combination with or in place of ethyl cellulose.

Suitable solvents include kerosene, mineral spirits, terpineol, esters of phthalic acid, such as dibutyl phthalate, butyl carbitol, butyl carbitol acetate, hexylene glycol, aliphatic di-esters, such as the ethyl and butyl esters of adipic and sebacic acids and high-boiling alcohols and alcohol esters. Various combinations of these and other solvents are formulated to obtain the desired viscosity, volatility and compatibility properties. Water-soluble solvent systems can also be used.

Among the thixotropic agents that are commonly used are hydrogenated castor oil and derivatives thereof and ethyl cellulose. It is, of course, not always necessary to incorporate a thixotropic agent since the solvent/resin properties coupled with the shear thinning inherent in any suspension may alone be suitable in this regard. Suitable wetting agents include phosphate esters and soya lecithin.

In addition to the metal particles and organic medium, the ink compositions also generally include an electronic glass or glass frit. The glass frit upon firing softens and then dissolves the surface passivation layer on the substrate, creating a pathway for metal particles to reach the silicon. Generally, the electronic glass or glass frit is a high purity glass material, such as is typically used for electronic component manufacturing, and such compositions are well known in the art. While the glass desirably should completely or essentially exclude Na and/or K (at least when silicon substrates are used, as these materials tend to migrate rapidly in silicon), typical glass compositions suitable for use in embodiments include PbO/ZnO glass, $SiO_2$ glass, $TiO_2$ glass, $B_2O_3$ glass, $ZrO_2$ glass, and the like. Other suitable examples of glass used in embodiments include $SiO_2/Bi_2O_3/PbO$, $B_2O_3/SiO_2/Bi_2O_3$, $Bi_2O_3/SiO_2/ZnO$, $Bi_2O_3/SiO_2/PbO$, and the like. In some embodiments, it is also desirable to minimize or eliminate the use of lead-containing materials, including to minimize or eliminate the use of lead glass, for environmental and health reasons. Suitable glass materials can be obtained, for example, from Viox Corp. (Seattle, Washington, USA).

The ratio of organic medium to solids in the ink composition dispersions can vary considerably and depends upon the manner in which the dispersion is to be applied and the kind of organic medium used. Normally, to achieve good coverage, the dispersions will contain complementarily by weight 40-90% solids and 60-10% organic medium. For example, the composition of embodiments may contain 45-65% by weight metal solids and 55-35% by weight organic medium, where the weight solids includes the weight of the glass material.

For example, in embodiments, the ink composition can have from about 50 to about 90%, such as about 65 to about 85% metal particles; about 1 to about 10%, such as about 2 to about 8% electronic glass; and about 5 to about 40%, such as about 10 to about 30%, organic component. In particular embodiments, the ink composition can have from about 70 to about 80%, such as about 75% metal particles; about 3 to about 7%, such as about 5% electronic glass; and about 15 to about 25%, such as about 20%, organic component. Regarding the organic component, the composition in embodiments can include about 25 to about 99%, such as about 40 to about 95% solvent; about 0 to about 40%, such as about 0 to about 35% plasticizer or co-solvent; about 1 to about 30%, such as about 5 to about 25%, resin (organic polymer); and about 0 to about 10%, such as about 0 to about 5% other additives. In particular embodiments, the organic component can include about 50 to about 90% solvent; about 0 to about 30% plasticizer or co-solvent; about 7 to about 15% resin; and about 0 to about 2% other additives. Unless otherwise noted, the percents are in terms of weight percent. Of course, the content of the ink composition, such as the content of metal particles, can be adjusted so as to adjust the rheological properties of the ink composition.

Other additives that can be added to the ink composition of embodiments, if desired, include one or more sintering aids, which can be included in known amounts for their known purpose. For example, suitable sintering aids include $SiO_2$, alkaline earth metal oxides, oxides from group III B and IV B of the periodic system, including the rare earth oxides, V, Nb, Ta, Cr, Fe, Co and/or Ni oxide, it being possible for said oxides to be used individually or in a mixture and/or in combination with $B_2O_3$, $Al_2O_3$ and/or $TiO_2$. When sintering aids are used in the ink composition, the sintering aids and/or residues thereof often remain present in the final sintered material.

Still further, in other embodiments, sintering inhibitors can be added to the ink composition, if desired. Sintering inhibitors can be used, for example, to help prevent delamination of the conductive metal lines during the sintering process. That is, it can be a problem during the rapid thermal annealing or sintering of thick (high aspect ratio) metal contacts onto silicon or silicon nitride surfaces that delamination of the rapidly densifying metal structures may occur. For example, the typical sintering profile used in the solar cell industry for silver contact metallizations is to use very fast heating and cooling rates of more than 50°C per second from room temperature to peak temperature typically between 600 to 850°C. The rapid sintering of discrete metal particles and the fundamental mismatch of thermal expansion coefficient between silicon and silver during processing can lead to delamination of high aspect ratio silver lines such as those of embodiments produced by coextrusion. Sintering inhibitors can thus be used to help control shrinkage of the metal layers for better matching to the substrate material, and thus to help prevent delamination of the conductive metal lines during sintering.

When sintering inhibitors are used, such materials can be in either particulate form or in the form of organometallic compounds that are soluble in the organic medium. However, if desired, the sintering inhibitors can be present as a coating on the metal particles in the ink composition. Such coatings can be produced by dispersing the conductive metal particles in a solution of a resinate of the metal of the sintering inhibitor, removing the bulk of the liquid from the dispersion and then drying the particles to form an oxide coating.

Suitable sintering inhibitors include oxides of rhodium (Rh) and ruthenium (Ru) and those rhodium- and ruthenium-based compounds that, under the firing conditions which they are subjected to, are changed to the oxides of the metals. For example, suitable Ru-based materials include Ru metal, $RuO_2$, Ru-based pyrochlore compounds such as bismuth lead ruthenate, and copper bismuth ruthenate, Ru resinates and mixtures thereof. Suitable Rh-containing materials include Rh metal, $RhO_2$, $Rh_2O_3$, Rh resinates and mixtures thereof. Both classes of materials are oxides of Rh or Ru or precursors of those oxides under air firing conditions of application. Particularly suitable sintering inhibitors are $RuO_2$, copper bismuth ruthenate, and Rh resinate. Additional detail of the use of sintering inhibitors can be found, for example, in U.S. Patents Nos. 5,162,062 and 4,954,926, the entire disclosures of which are incorporated herein by reference.

Such ink compositions can be formulated, for example, such that they exhibit desired firing parameters. For example, the ink compositions can be formulated such that the solvent and plasticizer/co-solvent are removed or burn-out during firing at about 150 to about 250°C, while the other components (resin and other additives) are removed or burn-out during firing at about 300 to about 500°C such as about 400 to about 500°C. The firing thus leaves behind the electronic glass component and the metal particles.

The ink compositions or pastes can be conveniently prepared on a three-roll mill. However, the compositions can also be made using conventional hot plates with heating and stirring, and the like. The viscosity of the composition is typically about 0.1 to about 300 Pa.s when measured at room temperature (about 20°C) on Brookfield viscometers at low (1 sec$^{-1}$), moderate (15 sec$^{-1}$) and high (200 sec$^{-1}$) shear rates. The amount and type of organic medium (vehicle) utilized is determined mainly by the final desired formulation viscosity and print thickness.

For example, one suitable composition includes silver particles, TEXANOL® solvent (2,2,4-trimethyl-1,3-pentanediol monoisobutylate), dibutyl phthalate, ethyl cellulose organic polymer, and castor oil such as hydrogenated castor oil. Modifications of such a composition can substitute, for example, longer chain phthalates such as dioctyl phthalate or diester phthalates for the dibutyl phthalate, or can substitute hydrogenated castor oil derivatives for the castor oil.

The ink composition is extruded, such as coextruded, with a sacrificial feedstock. In embodiments, the sacrificial feedstock can be extruded on one side of the extruded ink composition, it can be extruded on both sides of the extruded ink composition, or it can be extruded on three or even all four sides of the ink composition. For example, the sacrificial feedstock can be extruded on three sides of the extruded ink composition, so that it encapsulates the ink composition while the ink composition still contacts the substrate on the fourth (bottom) side. While embodiments allow the sacrificial feedstock to be underneath the ink composition, such a configuration is not desired in embodiments, as the sacrificial feedstock is desired to burn out during a subsequent firing step. Extrusion or co-extrusion on both lateral sides is desired, in embodiments, as the sacrificial material thereby helps maintain the ink composition in its desired extruded form, such as by preventing or minimizing any slump, flow, or the like of the ink vehicle. The sacrificial feedstock is maintained in place in contact with the ink composition as long as it is needed to help maintain the shape of the extruded ink composition on the substrate before or during any processing, such as drying, curing, firing and/or sintering. A further advantage of the sacrificial feedstock is that the added material leads to an overall larger output orifice for the extruder, and hence a lower pressure drop for a given material flow speed. Higher process speed is therefore achievable. A further advantage when convergent flow is used in the extruder is that the feature size of the extruded ink composition can be smaller.

The sacrificial feedstock and functional material provide a ribbon that is extrudable onto a substrate, such that the sacrificial feedstock maintains the functional material in place with an aspect ratio of greater than about 0.3 prior to removal of the sacrificial feedstock. Further, the sacrificial feedstock is removable from the ribbon by a process that maintains functional properties of the functional material.

In embodiments, the sacrificial feedstock desirably has some or all of the following properties: (1) it does not include, completely or substantially, any filler materials; (2) it completely burns out during firing or sintering of the contacting ink composition, such that the sacrificial feedstock is completely or substantially removed from the substrate; and (3) it has rheological properties, such as viscosity and the like, that completely or substantially match the rheological properties of the ink composition.

Generally speaking, the sacrificial feedstock can be of the same composition as the ink composition, described in detail above, except that the metal particles and electronic glass or frit (that would form the conductive structure upon sintering) are excluded from the sacrificial feedstock. That is, the sacrificial feedstock can correspond to, and in embodiments has the same components as, the organic component of the ink composition or other functional material. Thus, for example, the sacrificial feedstock may generally comprise an organic component, where the organic component can include, for example, a solvent, a combined plasticizer/solvent material, organic polymer, viscosity modifiers or builders, gelling agents, thixotropic agents, and the like. All of these materials, and others, that can be used in forming the organic component of an ink composition, and thus that can form the basis of the sacrificial feedstock, are discussed above. Of course, it will be apparent that while sintering aids and sintering inhibitors may be included in the functional material, such additives are not required in the sacrificial feedstock (especially where it is desired that the sacrificial feedstock burn away during sintering), and thus they can be completely or substantially excluded from the sacrificial feedstock.

As mentioned, the sacrificial feedstock in embodiments can be of the same composition as the organic component of the ink composition, or it can be of a different composition. Where the same composition is used, the properties of the sacrificial feedstock can be adjusted as necessary, for example to approach or equal the properties of the ink composition itself. Closely matched rheological properties, such as viscosity, are generally desired so that an extrusion or co-extrusion process can be conducted more easily with the two compositions. When necessary, the rheological properties, such as viscosity, can be adjusted by several means known in the art. For example, the viscosity of the sacrificial feedstock can be adjusted by adjusting (increasing or decreasing, as appropriate) the weight percent content of the organic polymer, by adjusting the molecular weight of the organic polymer, adding or adjusting a content of a gelling or other thickening agent, and the like. Such adjustments can be made, for example, by routine experimentation to closely match the properties of the ink composition or other functional material.

In embodiments, the sacrificial feedstock and the ink composition may be closely matched or substantially the same in one or more rheological properties. Since the co-extrusion process involves flows that are "mixed", i.e. have both extensional and shear components, it is appropriate that the matching be in both shear and extensional rheological properties. Moreover, since the flows involve local shear and deformation rates that may vary by orders of magnitude, matching of both "weak flow" and "strong flow" properties should be considered. Finally, the extrusion is a free surface flow, so surface properties need be considered as well. Thus, for example, matching can be in terms of shear and extensional viscosity (at all relevant shear and extension rates), loss and storage modulus, primary and secondary normal stress coefficient (at all relevant shear rates), elastic flow relaxation time, flow consistency index (which is the coefficient for a power-law fluid), flow behavior index (which is the exponent for a power law fluid), yield stress, surface tension and the like. Desirably, the sacrificial feedstock and the ink composition are closely matched or substantially the same in at least the shear viscosity and desirably one or more other properties. However, in other embodiments, the sacrificial feedstock and the ink composition are closely matched in at least two, at least three, or at least four or more of these properties.

For flow within the printhead the shear rate at a given location is approximated by the flow velocity in the printhead divided by the smallest lateral dimension (usually its height). The relevant shear rates are those where the sacrificial and functional inks meet. The same applies to the extension rate. It will thus be understood that the shear and extension rates depend both on the design of the printhead and the printing speed with which it is operated.

In embodiments, it is desired that shear viscosity of the sacrificial feedstock be just below, rather than exactly match or be above, the properties of the ink composition. That is, it has been found that better results are achieved when the shear viscosity of the sacrificial vehicle are just below the properties of the ink composition. This has been found empirically and is supported by the existing literature on co-extrusion. (See, for example, B. Khomami et al. "Experimental studies of interfacial instabilities in multilayer pressure-driven flow of polymeric melts, " Rheo. Acta 36, pp. 345-366 (1997) and H.K. Ganpule et al. "A theoretical investigation of interfacial instabilities in the three layer superposed channel flow of visco-elastic fluids," J. NonNewtonian Fluid Mech. 79, pp. 315-360 (1998), the entire disclosures of which are incorporated herein by references.)

For example, it is desired in embodiments to reduce, as much as possible, the elasticity in both the sacrificial feedstock and the functional material. This can be accomplished by standard means known in the art, for example, by reducing the molecular weight and/or the loading of the organic polymer in the particular material, reducing the molecular weight of any plasticizer that may be present, and, eliminating or minimizing the use of gelling agents. Of course, reducing the elasticity of the sacrificial feedstock and the functional material must be balanced against possible increased slumping of the materials, if gelling is not induced in the materials. If coating with elastic materials (and particularly highly elastic materials such as materials with high Weissenberg numbers) is desired, then a beneficial arrangement of the multi-layer extruded materials is to have the least viscous and least elastic material on the exterior, i.e. the sacrificial feedstock should be less viscous and less elastic than the functional material. It has been shown that the arrangement of less viscous/elastic outside of more viscous and elastic provided the most control over the long wavelength elastic instabilities (varicose or sinuous) with surface tension stabilizing short modes. See, for example, B. Khomami et al., "Experimental studies of interfacial instabilities in multilayer pressure-driven flow of polymeric melts," Rheo. Acta, 36, pp. 345-366 (1997) and H.K. Ganpule et al., "A theoretical investigation of interfacial instabilities in the three layer superposed channel flow of viscoelastic fluids," J. NonNewtonian Fluid Mech., 79, pp. 315-360 (1998), the entire disclosures of which are incorporated herein by references.

For example, in embodiments, the viscosity properties of the sacrificial feedstock are selected or adjusted such that they differ by no more than about 10% from the properties of the functional material such as the ink composition. This can be compared, for example, by calculating or measuring the viscosity of the two materials at varying temperatures, such as from about room temperature (about 20°C) to about 60°C or higher, and calculating the percentage difference between the sacrificial feedstock viscosity curve and the ink composition viscosity curve. However, in other embodiments, the shear viscosity curves, representing the shear viscosity versus shear rate over a broad range of rates (for example up to about 1000 sec$^{-1}$). can match each other for the two compositions, or the shear viscosity curve for the sacrificial feedstock can be lower than that for the ink composition.

Other metrics for the sacrificial feedstock, in embodiments, include a specified yield strength and specified viscosity and shear rate values. For example, in embodiments the sacrificial feedstock can have a yield strength of greater than about 100 Pa, such as greater than about 125 or greater than about 150 Pa, or a viscosity of greater than about $10^4$ cP, such as greater than about $5x10^4$ cP or greater than about $10^5$ cP, at a shear rate of less than about 10 sec$^{-1}$, such as at a shear rate of about 0.1 to about 1.0 sec$^{-1}$. These properties have been found to enable the ribbon to maintain sufficient structural integrity to allow firing to occur and to provide desired final results.

In other embodiments, the viscosity of the sacrificial feedstock is less than or equal to about five times a viscosity of the functional material at a shear rate of greater than about 100 sec$^{-1}$. In embodiments, the viscosity of the sacrificial feedstock is less than or equal to about five times a viscosity of the functional material at a shear rate of about 50 to about 500 sec$^{-1}$, such as about 100 to about 500 sec$^{-1}$.

The sacrificial material of embodiments can be a filled sacrificial feedstock or an unfilled sacrificial feedstock. Where the sacrificial material is a filled sacrificial feedstock, the material can have about 5% or more by volume, such as about 10 or about 15 to about 30 or about 50% or more by volume of discrete solid or gel-like particles.

However, in other embodiments, the sacrificial feedstock is an unfilled sacrificial feedstock. In these embodiments, the sacrificial feedstock does not include additional filler materials, such as carbon black or the like, that would not burn-out during the sintering process. Here, the material can have about 2% or less by volume, such as about 1 or about 0.5% or less by volume of discrete solid or gel-like particles. As described below, the firing of the applied extruded material when used for making solar cells can be conducted at about 600 to about 800°C for a time period of only a number of seconds. Thus, for example, the sacrificial feedstock in embodiments does not include materials that will not burn-out when fired at about 600 to about 800°C for a time period of less than one minute. Exemplary filler materials that are thereby wholly or substantially excluded from the sacrificial feedstock, in embodiments, thus include carbon black, plastic beads such as nylon spheres, ceramics, and the like. These types of filler materials can be either completely excluded from the sacrificial feedstock, or they can be present in only a minor amount that can be easily removed by post-firing processing to leave a clean substrate surface.

Similar to the desired exclusion of filler materials, the other materials of the sacrificial feedstock are also desirably selected such that the complete sacrificial feedstock burns-out during the firing process that sinters the applied conductive ink composition. Thus, for example, the materials of the sacrificial feedstock are selected such that they burn-out during firing at about 600 to about 800°C for a time period of less than one minute. As discussed with respect to the ink composition, the components of the sacrificial feedstock can be selected, for example, such that they exhibit desired firing parameters. For example, the sacrificial feedstock can be formulated such that the solvent and plasticizer/co-solvent are removed or burn-out during firing at about 150 to about 250°C, while the other components (resin and other additives) are removed or burn-out during firing at about 300 to about 500°C such as about 400 to about 500°C.

Proper selection of the sacrificial feedstock components thus allows the firing process to completely burn-out the sacrificial feedstock. As a result, few or none of the sacrificial feedstock components are left behind, and the underlying substrate is unaffected and exposed. Any residue that may remain can be readily removed by conventional post-processing or cleaning operations, if necessary.

In an embodiment of this disclosure, the sacrificial feedstock is allowed to dry, fully or partially, prior to a subsequent firing step. When the feedstock is permitted to dry, it dries to a volume and thickness that is substantially smaller than the wet volume and thickness of the extruded sacrificial feedstock. For example, when the wet extruded thickness of the sacrificial feedstock is on the order of about 100 microns thick, through a combination of spreading and drying, the final thickness of the extruded sacrificial feedstock can be on the order of only several microns. This relatively small volume of material is readily burned off during the thermal process cycle needed to fire the metal gridline of the solar cell or to fire the other functional materials.

The sacrificial feedstock can also be conveniently prepared on a three-roll mill. However, the compositions can also be made using conventional hot plates with heating and stirring, and the like. The viscosity of the composition is typically about 0.1 to about 300 Pa.s when measured at room temperature (about 20°C) on Brookfield viscometers at low, moderate and high shear rates. The amount and type of organic medium (vehicle) utilized is determined mainly by the final desired formulation viscosity and print thickness.

The functional material such as ink composition and sacrificial feedstock can be applied to the substrate in any suitable or desired manner. For example, the ink composition and sacrificial feedstock can be applied to a silicon substrate for making a solar cell, by applying the materials in the form of lines that will be fired to form conductive structures. When so applied, the ink composition can be applied with the sacrificial feedstock on one or both sides of the ink composition, to help maintain the shape or other properties of the ink composition. The ink composition and sacrificial feedstock can then be fired, which sinters the ink composition and burns-out the sacrificial feedstock, to form conductive structures. In embodiments, the sacrificial feedstock is desirably applied on both sides of the ink composition, to help support the ink composition on both sides and provide uniform conductive structures. Of course, the sacrificial feedstock can also be applied over the functional material, and/or optionally beneath the functional material, if desired.

A number of application devices can be used for applying the functional material such as ink composition and sacrificial feedstock to the substrate. Desirably, the ink composition and sacrificial feedstock are applied to the substrate using a co-extrusion device, as such devices allow for the two materials to be reliably and uniformly applied to the substrate, with the ink composition and sacrificial feedstock in mutual intimate contact along their boundary to provide the desired support properties. Suitable coextrusion devices are disclosed, for example, in U.S. Patent Publications Numbers 2007-0110836 A1, 2007-0108229 A1, and 2007-0107773 A1, and U.S. Patent Applications Nos. 11/336,714, 11/555,479, 11/555,512, 11/555,496, and 11/609,825, the entire disclosures of which are incorporated herein by reference.

When so applied by a coextruder device, the ink composition can be provided to have any desired high aspect ratio. For example, conventional screen printing techniques of applying ink compositions are suitable to provide aspect ratios of from about 0.1 to about 0.2, such as with a typical fired thickness of 10-20 microns and a width of 100-200 microns. However, the ink composition of embodiments, when applied with the disclosed sacrificial feedstock by coextrusion, can provide ink composition structures having much higher aspect ratios and much smaller dimensions.

In embodiments, the ink composition in its unfired state can have widths of from about 10 to about 100 microns, such as about 10 to about 90 microns or about 10 to about 75 microns, and thicknesses of from about 25 to about 200 microns, such as about 25 to about 100. For example, the widths can be about 10 to about 25 microns, about 25 to about 50 microns, about 50 to about 75 microns, or the like, and the thicknesses can be about 25 to about 50 microns, about 50 to about 75 microns, about 75 to about 100 microns, about 100 to about 150 microns, or the like.

The structures can in turn have minimum aspect ratios of about 0.2 or greater or about 0.3 greater or about 0.4 or greater, and maximum aspect ratios of up to about 1, up to about 2, or up to about 5. Although higher aspect ratios may also be achieved, aspect ratios above about 2 or about 3 tend to provide diminishing returns in many applications such as for solar cells, in that lesser benefit is obtained, and the features can become more fragile or more difficult to process. In embodiments, the aspect ratio in the unfired state can be, for example, from about 0.2 to about 10, such as about 0.3 to about 5 or about 0.4 or about 0.5 to about 1 or about 2 or about 3. Likewise, although it is understood that the structures tend to shrink during sintering, particularly in the thickness dimension, the structures after firing, in embodiments, can have minimum aspect ratios of about 0.2 or greater or about 0.3 greater or about 0.4 or greater, and maximum aspect ratios of up to about 1, up to about 2, up to about 3, or up to about 5. In embodiments, the fired structures can have higher aspect ratios, such as above about 10 or above about 20, although they tend to provide diminishing returns in many applications such as for solar cells. In embodiments, the aspect ratio in the fired state can be, for example, from about 0.2 or from about 0.3 or from about 0.4 or about 0.5 to about 1 or about 2, such as about 0.3 to about 3 or about 0.4 or about 0.5 to about 2.

When fired, the size, and particularly the thickness, of the ink composition tends to decrease as the ink composition sinters and compacts. For example, typical ink compositions upon firing tend to decrease in aspect ratio by a factor of about 0.6. That is, the aspect ratio of the fired ink composition is about 60% the aspect ratio of the unfired ink composition. Suitable ranges of aspect ratio for the fired ink composition or conductive structure is thus about 60% of the above aspect ratios for the unfired ink composition.

A particular advantage of embodiments of the ink composition and sacrificial material, applied by coextrusion, is a combination of high aspect ratio and small feature size. Thus, for example, the disclosure in embodiments can provide features (unfired ink composition structures) having a width of about 25 to about 75 microns, such as about 25 to about 50 microns, a thickness of about 50 to about 150 microns, such as about 50 to about 100 microns, and an aspect ratio of about 0.3 to about 3 such as about 0.5 to about 1 or about 2. These feature dimensions were not previously available with screen printing techniques.

Once the ink composition and sacrificial feedstock are applied to the substrate, the sacrificial feedstock can be removed, leaving the functional material in place. This removal can be conducted, for example, by processes including one or more of pyrolysis, burning, dissolution, dispersion, and washing. The following discussion is provided with respect to a firing process, although modifications will be apparent. Thus, for example, the combined materials of sacrificial feedstock and functional material can be fired. Firing is effective to sinter the ink composition, burn-out organic components of the ink composition, and burn-out the sacrificial feedstock, to provide sintered structures such as conductive lines on the substrate. Sintering can be conducted under a variety of different heating profiles. However, while sintering in the ceramic industry is typically on the order of several hours at temperatures of 1200-1600°C, sintering of conductive ink compositions for example for solar cell production typically uses a sharper spiked profile, at faster times at lower temperatures. Furthermore, the sintering should account for the fact that while thin structures can be more easily sintered to avoid delamination, thicker structures are more susceptible to delamination as the material shrinks.

In embodiments, the ink compositions are typically designed to withstand peak sintering temperatures for up to about 10 minutes. Thus, for example, the sintering can be conducted such that peak temperature is maintained for only up to about 1 minute, up to about 2 minutes, or up to about 5 minutes. These times are sufficient to provide the sintering effect to the ink composition and to burn-out the organic components of the ink composition and sacrificial material. In particular embodiments, the peak sintering temperature is from about 500 to about 1200°C, such as from about 500 to about 1000°C, while more desired peak sintering temperatures are from about 600 to about 800°C such as from about 650 to about 750°C.

In one exemplary embodiment, the furnace used to dry and/or fire the substrate with the extruded ribbon of sacrificial feedstock and functional material can be am IR bulb furnace, generally capable of a peak temperature of 1000°C, high belt speeds and rapid product cool-down as the product comes out of the final firing zone. Production furnaces would generally have both a drying and a firing section. RTC production furnaces, for example, are essentially two furnaces on the same belt, with a physical break between the drying and firing sections. Having sequential drying and firing on the same belt more-or-less doubles the length of the furnace. Thus, where space is a problem, a single furnace can be used, where coated substrates are first dried in the furnace, and then the furnace is heated to firing temperatures and the substrates are then fired. Alternatively, drying can be conducted in a box oven, followed by firing in the furnace.

Any suitable firing atmosphere can be used during the firing process. For example, many ink composition can be fired under normal atmosphere, while some ink compositions, such as copper inks, may be better fired under more inert atmospheres, such as under a nitrogen or argon atmosphere.

After firing is completed, any desirable or necessary post-processing steps can be conducted. For example, post-firing cleaning may be desired to remove any firing debris, such as debris from the sacrificial material or the ink composition. Other steps, such as polishing or the like, may also be employed. In the case of solar cell production, it is also common practice to test the cells after firing and to sort the cells according to the efficiency with which they convert light energy into electricity.

The sacrificial feedstock and functional material compositions of the disclosure can be used in a variety of applications where high aspect ratio conductive metal lines are desired. For example, particular applications include use in forming conductive lines for solar cell fabrication, use in forming barrier ribs (pixel separators) in plasma display panels, forming components of thick film heaters, forming components in fuel cell applications, and the like. The sacrificial feedstock and functional material compositions of the disclosure can be used both to form high aspect ratio lines, as well as higher conductivity lines for these and other applications.

One particular advantageous use of the compositions and methods of the disclosure is thus in solar cell production.

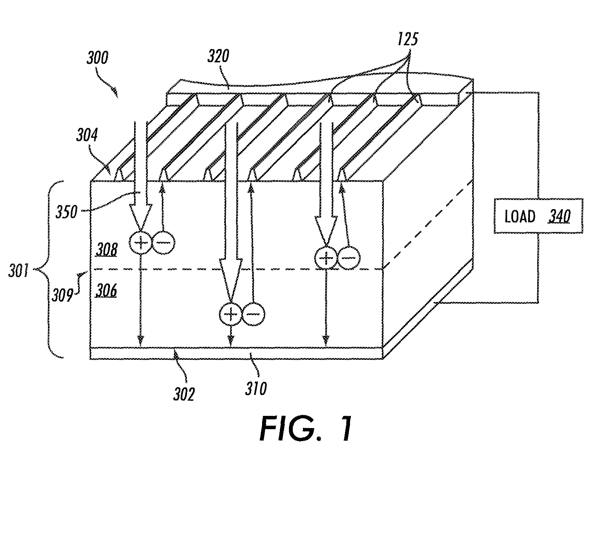

FIG. 1 illustrates an exemplary portion of a photovoltaic cell 300, such as a solar cell, with high-aspect metal gridlines 125 created using co-extrusion of the ink composition and sacrificial material according to an embodiment. Photovoltaic cell 300 includes a semiconductor substrate 301 with a p-type region 306 and an n-type region 308. One or both of the regions 306 and 308 of substrate 301 is formed from semiconductor materials such as, for example, aluminum arsenide, aluminum gallium arsenide, boron nitride, cadmium sulfide, cadmium selenide, copper indium gallium selenide, diamond, gallium arsenide, gallium nitride, germanium, indium phosphide, silicon, silicon carbide, silicon nitride, silicon germanium, silicon on insulator, zinc sulfide, zinc selenide, or the like. A lower contact 310 is formed on a lower surface 302 of substrate 301 (i.e., at a lower end of p-type region 306). Metal gridlines 125 and one or more bus bars 320 are formed on an upper surface 304 of substrate 301 (i.e., at a lower end of n-type region 308). Contact 310 and bus bars 320 can be formed using a metal paste such as a silver based paste or an aluminum based paste, which can be the same as or different from the ink composition described herein as useful for forming the metal gridlines.

Photovoltaic cell 300 can be interconnected with other photovoltaic cells (not shown) in series and/or parallel, for example, via flat wires or metal ribbons, and assembled into modules or panels and connected as indicated to a load 340. A sheet of clear material (not shown), such as glass (glass sheet or spin-on glass), tempered glass, plastic, or the like, may be layered over the gridlines 125 and/or a polymer encapsulation (not shown) may be formed over the contact 310. Upper surface 304 may include a textured surface and/or be coated with an antireflection material (e.g., silicon nitride, titanium dioxide, or the like) in order to increase the amount of light absorbed into the cell.

During operation, when photons 350 (indicated by wide arrows) are directed into substrate 301 through upper surface 304, their energy excites electron-hole pairs therein, which subsequently freely move. In particular, absorption of a photon creates an electric current through the p-n junction 309 (depicted by the migrating + and - charges). Electrical current is generated when excited electrons in the n-type region 308 travel through gridlines 125, bus bar 320, and the electrodes to external load 340 and back through the lower electrode and contact 310 to the p-type region 306.

By way of example, a co-extrusion head with the estimated parameters illustrated in Table 1 could be used to dispense the materials to make gridlines 125 on a crystalline silicon solar cell.

Table 1.

Exemplary head parameters for generating a gridline.

| | | |
|---|---|---|
| Nozzle Height | 0.01 | cm |
| Nozzle Width | 0.025 | cm |
| Line Pitch | 0.175 | cm |
| Print Speed | 11.5 | cm/sec |
| Paste Consistency | 100,000 | centiPoise |
| Power Law Index | 0.65 | |
| Nozzle Angle | 60 | degrees |
| Metal Line Width | 0.005 | cm |
| Metal Line Cross Section | 5000 | microns |
| Metal Line Aspect Ratio | 2 | :1 |
| Metal Ink Flow | 0.00058 | cc/sec/nozzle |
| Linewidth Compression | 5 | :1 |
| Printhead Pressure Drop | 210.3 | PSI |

With this design, convergent channels are patterned into a sheet of material with a thickness of approximately 0.01 cm, which determines the height of the nozzle, and thereby the approximate height or thickness of the extruded line. The outlet orifices of the head/nozzles are repeated on a pitch of 0.175 cm. At a head/nozzle pressure of approximately 210 PSI, ink composition (paste) and sacrificial material is ejected at a rate of 11 cm/sec. The central stripe of silver is approximately 50 microns wide with an aspect ratio of 2:1. The paste viscosity $\mu_{eff}$ as a function of the shear rate $\left(\dfrac{\partial u}{\partial y}\right)$ can, for some shear thinning materials, be described by a consistency K and a power law index n according to the Ostwald-de Waele power law.

$$\mu_{eff} = K\left(\frac{\partial u}{\partial y}\right)^{n-1}.$$

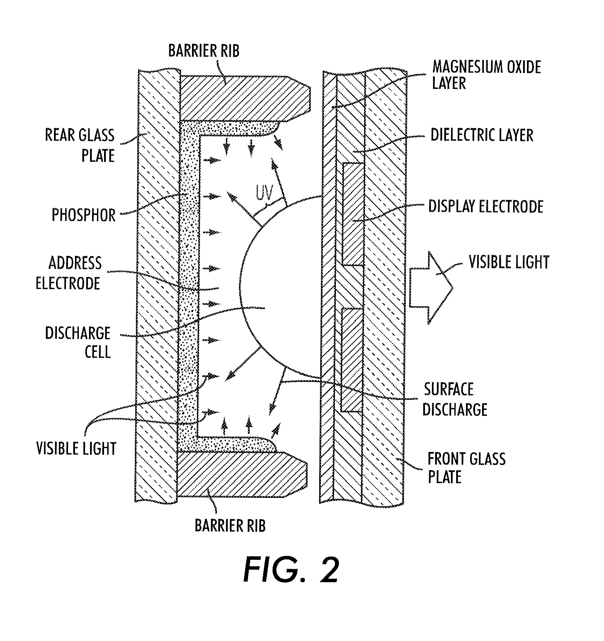

Another exemplary use of the materials and processes of the disclosure, which benefits from rapid and economical means for generating high aspect ratio lines and features, is in the fabrication of plasma display panels. For example, FIG. 2 shows a plasma display panel where high aspect-ratio barrier ribs define the subpixels within the display. The barrier rib is an electrically insulating structure, and is preferably a high aspect ratio structure, as this improves the dot per inch resolution and fill factor of the display.

The present disclosure, in embodiments, provides a range of benefits and advantages over the prior art. For example, coextrusion of the ink composition rather than screen printing techniques, to provide smaller feature size and higher aspect ratio, can improve the efficiency of energy production in solar cells. Thus, whereas conventional commercial design of solar cells provide efficiencies of about 15% (with the theoretical maximum efficiency being 29%), embodiments made by the present disclosure can raise the efficiency to about 16%. Although the 1 % change in efficiency may facially not seem significant, that 1% change actually amounts to a 6.7% increase in efficiency over the conventional designs, which translates to significant energy production savings.

Another advantage of the disclosure is that significant cost and material savings can be achieved. For example, because smaller conductive structures can be formed, less conductive metal and other materials are required. In addition, the co-extrusion process can be performed at a faster rate, with lesser maintenance and downtime, as compared to conventional screen printing techniques.

The ink compositions and sacrificial materials of the disclosure, which can be applied by coextrusion techniques, also allows for precise patterning of high aspect ratio structures. While the materials and processes can generally be used in any application where screen printing has been used, the materials and processes of the disclosure allow for higher aspect ratio structures of smaller overall size (particularly smaller width) than was generally possible using screen printing.

Furthermore, coextrusion provides important advantages over screen printing in terms of process time. For example, because the coextrusion printers have longer maintenance-free periods, particularly where materials are selected to avoid clogging of the extruder die, the process equipment can be operated for longer periods of time on a continuous basis without needing to replace or repair screens. Further, processing time for coextrusion are generally faster than for screen printing processes, allowing significant increases in process throughput.

An example is set forth herein below and is illustrative of different compositions and conditions that can be utilized in practicing the disclosure. All proportions are by weight unless otherwise indicated. It will be apparent, however, that the disclosure can be practiced with many types of compositions and can have many different uses in accordance with the disclosure above and as pointed out hereinafter.

EXAMPLES

Example 1 - Preparation of Sacrificial Materials:

A sacrificial feedstock was formed using the following components:

| Component | Weight % |
|---|---|
| Texanol[1] | 65 |
| Dibutyl phthalate | 22 |
| Ethyl cellulose std 45[2] | 12 |

(continued)

| Component | Weight % |
|---|---|
| Thixatrol ST | 1 |

[1] Texanol is 2,2,4-trimethyl-1,3-pentanediol 1-monoisobutryate
[2] Ethyl cellulose std 45 is a standard ethyl cellulose polymer having an ethoxyl content of 48.0 to 49.5%, where a 5% solution of the polymer in an 80% toluene/20% ethanol solvent blend will have a viscosity of about 45 centipoise (millipascal-seconds)

The feedstock is formed by blending the resin with the solvent and plasticizer at elevated temperature, with shearing to thoroughly disperse the resin. A propeller stirrer or centrifugal mixer can be used for the blending. Once the resin is dissolved, the castor wax gelling agent (Thixatrol ST) is added when the solution is in a specified temperature range, and blended with high shear (e.g. high speed propeller). Next, the solution is cooled while stirring.

Comparative Example 1 - Preparation of Sacrificial Materials:

A sacrificial feedstock was formed using the following components:

| Component | Weight% |
|---|---|
| Texanol | 68 |
| Carbon black | 22.7 |
| Ethyl cellulose std 45 | 7.7 |
| Thixatrol ST | 1.5 |

The feedstock is formed by blending the resin with the solvent and filler at elevated temperature, with shearing to thoroughly disperse the resin. A propeller stirrer or centrifugal mixer can be used for the blending. Once the resin is dissolved, the castor wax gelling agent (Thixatrol ST) is added when the solution is in a specified temperature range, and blended with high shear (e.g. high speed propeller). Next, the solution is cooled while stirring.

Comparative Example 2 - Preparation of Sacrificial Materials:

A sacrificial feedstock was formed using the following components:

| Component | Weight% |
|---|---|
| Texanol | 42.1 |
| Microthene FN 519 (low density polyethylene spheres) | 52.1 |
| Ethyl cellulose std 45 | 4.8 |
| Thixatrol ST | 1.0 |

The feedstock is formed by blending the resin with the solvent and filler at elevated temperature, with shearing to thoroughly disperse the resin. A propeller stirrer or centrifugal mixer can be used for the blending. Once the resin is dissolved, the castor wax gelling agent (Thixatrol ST) is added when the solution is in a specified temperature range, and blended with high shear (e.g. high speed propeller). Next, the solution is cooled while stirring.

Example 2 - Preparation of Ink Materials:

A conductive ink composition is prepared using the following components:

| Component | Weight% |
|---|---|
| Silver flakes | 77 |
| Glass frit | 4.0 |
| Texanol | 16.7 |
| Ethyl cellulose std 45 | 1.9 |
| Thixatrol ST | 0.4 |

The ink is formed by blending the silver particles with the other ink components using a conventional blending device, such as a propeller stirrer or a three-roll mill.

Example 3 - Coextrusion of Ink and Sacrificial Material:

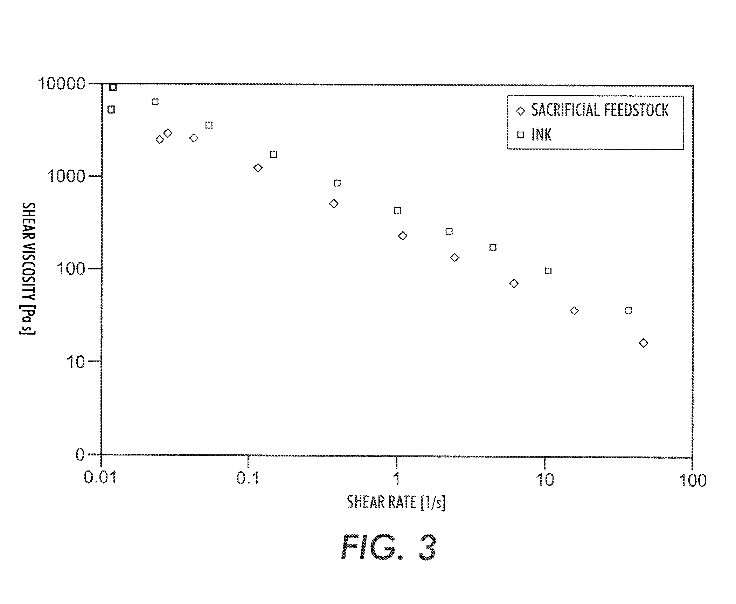

As a suitable silver ink, a silver ink composition having rheological properties, particularly shear viscosity versus shear rate, closely matched to the sacrificial feedstock, is selected for coextrusion with the above sacrificial feedstocks. For purposes of comparison of the shear viscosity properties of the ink and sacrificial feedstock materials, a plot of shear viscosity (in Pa-s) versus shear rate (in 1/sec) for the materials of in shown in Fig. 3.

The sacrificial material of Example 1 is used for coextrusion, as its rheological properties closely match those of the silver ink. The ink and sacrificial feedstock are coextruded onto a solar cell substrate, by placing each material into separate dispensing apparatuses, such as positive displacement pumps or pneumatic syringe pumps. The pumps are in turn connected to the inlet ports of a coextrusion printhead. Pressure is applied to the sacrificial feedstock and to the ink by their respective pumps, causing the fluids to flow into the printhead. Inside the printhead, the fluids are distributed to arrays of separated channels by separate plenums that distribute the sacrificial feedstock and ink to their respective arrays of channels. From the channels, the fluids enter an array of nozzles in which laminar flows of sacrificial feedstock and ink are combined into a common laminar flow that is coextruded from the outlet nozzle orifices of the printhead. The substrate is translated relative to the printhead at a controlled speed and at a controlled separation distance between the substrate and the printhead. This results in a bead of fluid deposited onto the substrate comprising a ribbon of ink with an aspect ratio of greater than 0.3, and surrounding portions of sacrificial material.

Firing of the coextruded sacrificial feedstock and silver ink completely burns out the sacrificial feedstock and sinters the conductive ink, leaving a conductive silver trace or line on the solar cell substrate.

Comparative Examples 3-4 - Coextrusion of Ink and Filled Sacrificial Material:

The procedure of Example 4 is repeated, except that the filled sacrificial feedstocks of Comparative Examples 1 and 2 are used in place of the sacrificial feedstock of Examples 1. Firing of the respective coextruded ribbons of sacrificial feedstock and silver ink results in incomplete burn-out of the sacrificial feedstock, leaving sacrificial feedstock residue next to the sintered conductive ink. The sacrificial feedstock residue covers portions of the solar cell substrate, causing decreased efficiency of the solar cell.

It will be appreciated that various of the above-disclosed and other features and functions, or alternatives thereof, may be desirably combined into many other different systems or applications. Also that various presently unforeseen or unanticipated alternatives, modifications, variations or improvements therein may be subsequently made by those skilled in the art which are also intended to be encompassed by the following claims.

**Claims**

1. A sacrificial feedstock for extrusion of ribbons, the ribbons comprising sacrificial extrudate and high-aspect-ratio functional material, said sacrificial feedstock comprising:

   an organic polymer,
   a solvent, and
   one or more optional additives,

wherein the sacrificial feedstock has a yield strength of greater than about 100 Pa or a viscosity of greater than about $10^4$ cP at a shear rate of less than about 10 sec$^{-1}$ to enable the ribbon to maintain structural integrity, and the sacrificial feedstock can be removed from the ribbon, leaving the functional material in place with an aspect ratio of greater than about 0.3.

2. The sacrificial feedstock of claim 1, wherein the functional material is selected from the group consisting of a conductive material, a material comprising a semiconductor dopant, a photoresist material, and a ceramic material.

3. The sacrificial feedstock of claim 1, wherein the sacrificial material consists essentially of the solvent, the organic polymer, and one or more optional additives selected from the group consisting of thixotropic agents, gelling agents, plasticizers, co-solvents, wetting agents, and viscosity modifiers or builders.

4. A material set, comprising:

a sacrificial feedstock comprising an organic polymer, a solvent, and one or more optional additives, and a functional material that forms a ribbon with the sacrificial feedstock without the sacrificial feedstock and the functional material substantially intermixing,
wherein the sacrificial feedstock has a yield strength of greater than about 100 Pa or a viscosity of greater than about $10^4$ cP at a shear rate of less than about 10 sec$^{-1}$ to enable the ribbon to maintain structural integrity, and the sacrificial feedstock can be removed from the ribbon, leaving the functional material in place with an aspect ratio of greater than about 0.3.

5. The material set of claim 4, wherein the functional material is a conductive ink or conductive ink precursor composition comprising metal particles, an electronic glass, an organic component, and one or more optional additives.

6. The material set of claim 4, further comprising an organometallic compound or metal resinate.

7. The material set of claim 4, wherein the organic component comprises a solvent, an organic polymer, and one or more optional additives.

8. The material set of claim 7, wherein the one or more optional additives are selected from the group consisting of thixotropic agents, gelling agents, plasticizers, co-solvents, wetting agents, and viscosity modifiers or builders.

9. An extruded ribbon of material, comprising:

a functional material having an aspect ratio of 0.3 or greater, and
an unfilled sacrificial material on at least one side of the functional material, the sacrificial material comprising an organic polymer, a solvent, and one or more optional additives,
wherein the sacrificial material has a yield strength of greater than about 100 Pa or a viscosity of greater than about $10^4$ cP at a shear rate of less than about 10 sec$^{-1}$ to enable the ribbon to maintain structural integrity, and the sacrificial material can be removed from the ribbon, leaving the functional material in place with an aspect ratio of greater than about 0.3.

10. The extruded ribbon of claim 9, wherein the functional material is a conductive ink comprising metal particles, an electronic glass, an organic component, and one or more optional additives.

11. A combination comprising:

a substrate, and
an extruded ribbon of material on said substrate, said extruded ribbon comprising:

a functional material having an aspect ratio of 0.3 or greater, and
an unfilled sacrificial material on at least one side of the functional material, the sacrificial material comprising an organic polymer, a solvent, and one or more optional additives,
wherein the sacrificial material has a yield strength of greater than about 100 Pa or a viscosity of greater than about $10^4$ cP at a shear rate of less than about 10 sec$^{-1}$ to enable the ribbon to maintain structural integrity, and
the sacrificial material can be removed from the ribbon, leaving the functional material in place with an aspect ratio of greater than about 0.3.

**12.** The combination of claim 11, wherein the substrate is a silicon substrate.

**13.** A method for forming conductive lines on a substrate, comprising:

extruding a ribbon of a functional material having an aspect ratio of 0.3 or greater and a sacrificial material on at least one side of the functional material,
wherein the sacrificial material comprises an organic polymer, a solvent, and one or more optional additives,
the sacrificial material has a yield strength of greater than about 100 Pa or a viscosity of greater than about $10^4$ cP at a shear rate of less than about 10 sec$^{-1}$ to enable the ribbon to maintain structural integrity, and
the sacrificial material can be removed from the ribbon, leaving the functional material in place with an aspect ratio of greater than about 0.3.

**14.** A solar cell structure, comprising:

a substrate; and
at least one gridline formed on the substrate,
wherein the at least one gridline has an aspect ratio of at least about 0.3 and is formed by a method comprising extruding onto the substrate a ribbon of a functional material having an aspect ratio of 0.3 or greater and a sacrificial material on at least one side of the functional material,
wherein the sacrificial material comprises an organic polymer, a solvent, and one or more optional additives,
the sacrificial material has a yield strength of greater than about 100 Pa or a viscosity of greater than about $10^4$ cP at a shear rate of less than about 10 sec$^{-1}$ to enable the ribbon to maintain structural integrity, and
the sacrificial material can be removed from the ribbon, leaving the functional material in place with an aspect ratio of greater than about 0.3.

**15.** The solar cell structure of claim 14, wherein the substrate is formed from a semiconductor material selected from the group consisting of aluminum arsenide, aluminum gallium arsenide, boron nitride, cadmium sulfide, cadmium selenide, copper indium gallium selenide, diamond, gallium arsenide, gallium nitride, germanium, indium phosphide, silicon, silicon carbide, silicon nitride, silicon germanium, silicon on insulator, zinc sulfide, and zinc selenide.

FIG. 1

BARRIER RIB

MAGNESIUM OXIDE
LAYER

REAR GLASS
PLATE

DIELECTRIC LAYER

PHOSPHOR

UV

DISPLAY ELECTRODE

VISIBLE LIGHT

ADDRESS
ELECTRODE

DISCHARGE
CELL

VISIBLE LIGHT

SURFACE
DISCHARGE

FRONT GLASS
PLATE

BARRIER RIB

## FIG. 2

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20040200520 A1
- US 4954926 A
- GB 772675 A
- US 5162062 A
- US 20070110836 A1
- US 20070108229 A1
- US 20070107773 A1
- US 336714 A
- US 11555479 A
- US 11555512 A
- US 11555496 A
- US 11609825 A

### Non-patent literature cited in the description

- **RICHARD M. SWANSON.** Approaching the 29% Limit Efficiency of Silicon Solar Cells. *31s IEEE Photovoltaic Specialists Conference,* 2005
- Ken-React Bul. No. KR-0278-7 Rev. Kenrich Petrochemicals, Inc,
- **B. KHOMAMI et al.** Experimental studies of interfacial instabilities in multilayer pressure-driven flow of polymeric melts. *Rheo. Acta,* 1997, vol. 36, 345-366
- **H.K. GANPULE et al.** A theoretical investigation of interfacial instabilities in the three layer superposed channel flow of visco-elastic fluids. *J. NonNewtonian Fluid Mech.,* 1998, vol. 79, 315-360
- **H.K. GANPULE et al.** A theoretical investigation of interfacial instabilities in the three layer superposed channel flow of viscoelastic fluids. *J. NonNewtonian Fluid Mech.,* 1998, vol. 79, 315-360